(19) Europäisches Patentamt
European Patent Office
Office européen des brevets

(11) Publication number : **0 588 591 A1**

# (12) EUROPEAN PATENT APPLICATION

(21) Application number : **93307220.9**

(22) Date of filing : **14.09.93**

(51) Int. Cl.[5] : **C08K 3/36,** C08K 7/14, C08L 81/02

(30) Priority : **15.09.92 US 945202**

(43) Date of publication of application : **23.03.94 Bulletin 94/12**

(84) Designated Contracting States : **AT BE CH DE DK ES FR GB GR IE IT LI LU MC NL PT SE**

(71) Applicant : **HOECHST CELANESE CORPORATION**
**Route 202-206 North**
**Somerville, N.J. 08876 (US)**

(72) Inventor : **Wadhwa, Lachhman H.**
**6 Pueblo Trail**
**Somerset, New Jersey 08876 (US)**
Inventor : **Naviello, Gerard P.**
**612 Liberty Avenue**
**Jersey City, New Jersey 07307 (US)**
Inventor : **Zorrilla, Andres**
**982 Potter Avenue**
**Union, New Jersey 07083 (US)**

(74) Representative : **De Minvielle-Devaux, Ian Benedict Peter et al**
**CARPMAELS & RANSFORD 43, Bloomsbury Square**
**London WC1A 2RA (GB)**

## (54) Reinforced poly(arylene sulfide)resins having reduced flash.

(57) Molding compositions which comprises a melt blend of :
(a) poly(arylene sulfide) ;
(b) reinforcing filler ; and
(c) a flash reducing amount of an amorphous silica having a surface area of from about 50 to about 500 $m^2/g$,
wherein the composition has a melt viscosity of from about 150 to about 900 Pa.S at 400 $sec^{-1}$ and 316°C.

FIG. I

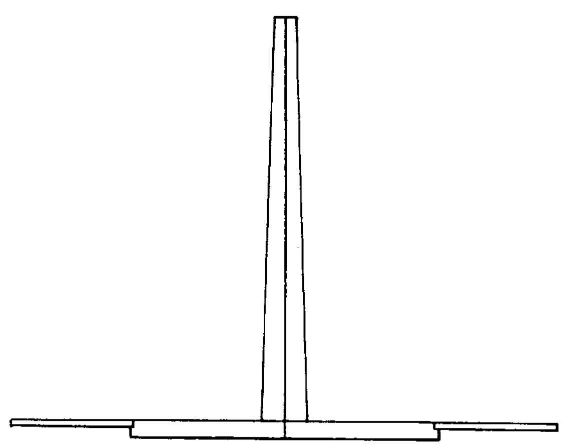

EP 0 588 591 A1

## BACKGROUND OF THE INVENTION

### 1. FIELD OF THE INVENTION

This invention relates to reinforced poly(arylene sulfide) resins, particularly, glass filled poly(phenylene sulfide) resins having reduced flash.

### 2. DESCRIPTION OF THE PRIOR ART

Poly(arylene sulfide) resins are widely used in molding applications requiring the use of thermally and dimensionally stable materials. Owing to their relatively low melt viscosities, poly(arylene sulfide)s exhibit rheology or "flow" characteristics that are especially useful in the manufacture of many thin-walled or dimensionally complex parts. The addition of reinforcing filler, such as glass or mica, tends to increase the strength and raise the heat deflection temperature ("HDT") of poly(arylene sulfide)s, producing resins capable of withstanding the processing conditions associated with many wave, vapor phase reflow, and IR soldering techniques. The rheological and thermal properties of reinforced poly(arylene sulfide)s are particularly well suited to numerous applications in the electrical/electronics industry, for example, in the production of molded circuit boards, connectors, chip carriers, and the like

The trend toward miniaturization in the electrical/electronics industry has created the need for easily processable resins which minimize the amount of flash in molded parts. Flash is defined as the unwanted flow and solidification of resin in an area of mold clearance. In miniaturized components, for example, connectors, the presence of flash can result in problems mating matched parts or inserting conductor pins. Although various tumbling and blasting techniques have been developed to remove flash from molded parts, the effectiveness of these "deflashing" techniques is often limited by size or tolerance requirements of a particular end-use application. Additionally, deflashing adds to the cost and time of part manufacture.

Different approaches to reducing flash have been suggested. One approach focuses on modifying melt rheology by increasing the viscosity of the poly(arylene sulfide) through cross-linking. Cross-linking results in a more viscous material that is less likely to seep through mold clearances. Excessive polymer crosslinking can, however, result in poor melt flow and incomplete mold fill. At times, flow loss resulting from excessive cross-linking can be compensated for by modifying processing conditions, for example, by increasing melt temperatures, injection pressures and/or mold temperatures. Unfortunately, such processing modifications may be undesirable from a cost perspective. Additionally, excessive cross-linking may negatively impact the physical properties, particularly, the elongation, tensile strength and impact resistance of molded parts.

It has also been proposed to reduce flash by minimizing mold clearances. While this technique may be of value with respect to new molds, use and wear inevitably result in increased clearances. Thus, mold design "solutions" to flash tend to be relatively short-lived and, given the cost of mold replacement, financially impractical.

An object of this invention is to provide reinforced poly(arylene sulfide) compositions having reduced flash. In a further embodiment, it is an object of this invention to provide reinforced poly(arylene sulfide) compositions wherein flash is reduced without significantly increasing the compositions' melt viscosity. In yet another embodiment, it is an object of this invention to improve the ability of reinforced poly(phenylene sulfide) compositions to produce molded parts with minimum flash without significantly detracting from the processing characteristics of such compositions.

These and other aspects of this invention are described in greater detail in the description and examples which follow.

## SUMMARY OF THE INVENTION

In accordance with this invention, it has been found that the use of relatively small amounts of a very finely divided amorphous silica in combination with poly(arylene sulfide) and reinforcing filler can be used to provide molding compositions having reduced flash. Thus, in one embodiment, this invention relates to a molding composition which comprises a melt blend of:

(a) poly(arylene sulfide);

(b) reinforcing filler; and

(c) a flash reducing amount of an amorphous silica having a surface area of from about 50 to about 500 $m^2/g$,

wherein the melt blend has a melt viscosity of from about 150 to about 900 Pa.S at 400 $sec^{-1}$ and 316°C.

In accordance with the practice of this invention, reductions in flash can be achieved irrespective of whether or not the poly(arylene sulfide) component is cross-linked, however, when at least a portion of the poly(arylene sulfide is cross-linked or a cross-linking agent is present, reductions in flash are particularly significant. Thus, in a further embodiment this invention relates to a melt blend which comprises:

(a) a poly(arylene sulfide), at least a portion of which is cross-linked;

(b) up to about 60 percent by weight, based on the total weight of the composition of reinforcing filler;

(c) and from about 1 to about 10 percent by weight, based on the weight of the poly(arylene sulfide), of an amorphous silica having a surface area of from about 50 to about 500 $m^2/g$,

wherein the melt blend has a melt viscosity of from about 150 to about 900 Pa.S at 400 $sec^{-1}$ and 316°C.

It has also been found that when the amorphous silica component is a hydrophobic fumed silica which is added in amounts of from about 1 to about 5 percent by weight, based on the weight of the poly(arylene sulfide), the tendency of the resultant compositions to flash is reduced, without significantly increasing the compositions' melt viscosity. Thus, in another embodiment, this invention relates to improved reinforced poly(arylene sulfide molding compositions) having melt viscosities of from about 150 to about 900 Pa.S at 400 $sec^{-1}$ and 316°C wherein the improvement comprises incorporating into such compositions from about 1 to about 5 percent, based on the weight of the poly(arylene sulfide), of hydrophobic fumed silica.

In a further embodiment this invention relates to a process for reducing the flash of poly(arylene sulfide) compositions which comprises the steps of:

(A) combining:

(a) a poly(arylene sulfide);

(b) up to about 60 percent by weight, based on the total weight of the composition, of reinforcing filler; and

(c) from about 1 to about 10 percent by weight, based on the weight of the poly(arylene sulfide), of an amorphous silica having a surface area of from about 50 to about 500 $m^2/g$, to form a raw material charge, and

(B) extruding the resulting raw material charge to produce a poly(arylene sulfide) composition which is a melt blend having a melt viscosity of from about 150 to 900 Pa.S at 400 $sec^{-1}$ and 316°C,

wherein the poly(arylene sulfide) is cross-linked by means selected from the group consisting of:

(1) incorporation into the raw material charge of up to about 5 percent by weight, based on the weight of the poly(arylene sulfide), of a cross-linking agent, with the proviso that when a cross-linking agent is incorporated into the raw material charge, the poly(arylene sulfide) prior to cross-linking is a linear material having a melt viscosity of from about 5 to about 400 Pa.S at 1200 $sec^{-1}$ and 310°C,

(2) curing the poly(arylene sulfide) prior to incorporation into the raw material charge, and

(3) curing the poly(arylene sulfide) subsequent to extrusion.

## DETAILED DESCRIPTION OF THE INVENTION

Melt viscosity is an important element in the practice of this invention. While it is generally recommended that the subject compositions have melt viscosities of from about 150 to about 900 Pa.S at 400 $sec^{-1}$ and 316°C, viscosities of preference will be dependent in part, on the particular end-use application. When attaining complete mold fill is a concern, for example, in the production of thin-walled or dimensionally complex parts, lower melt viscosities, i.e., from about 150 to about 400 Pa.S at 400 $sec^{-1}$ and 316°C, may be preferred. Melt viscosities in a higher range i.e., from about 350 to about 900 Pa.S at 400 $sec^{-1}$ and 316°C may be of interest where greater tensile strength or creep resistance is desired.

It will be readily apparent to those skilled in the art that the viscosity of the subject compositions will be determined, to a great extent, by the viscosity of the poly(arylene sulfide) component. The viscosity of the poly(arylene sulfide) component is itself largely dependent on molecular weight, polymeric structure, and the extent to which the poly(arylene sulfide) is cross-linked or "cured".

The poly(arylene sulfide) ("PAS") component of this invention is a polymer consisting essentially of repeating units of the formula:

$$-[Ar - S]-$$

wherein Ar for an individual repeating unit is a divalent radical selected from the group consisting of:

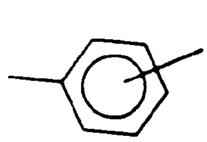 ,

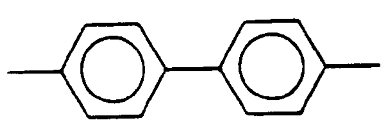 ,

and

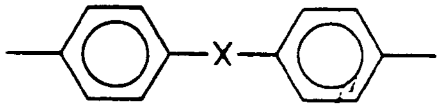

wherein X is a divalent radical selected from the group consisting of - $SO_2$ -, - C(O) -, - O -, - $C_aH_{2a}$ -, and - $C(CH_3)_2$ - wherein a is an integer having a value of 0 to 3. Optionally, the aromatic rings of the individual radicals Ar are substituted by from 1 to 3 substituents selected from the group consisting of alkyl groups having up to 4 carbon atoms, and fluorine, chlorine and bromine radicals. Mixtures of two or more different poly(arylene sulfide)s are also suitable for use herein. For purposes of this invention unsubstituted polymers are of particular interest, with poly(phenylene sulfide)s being preferred.

The poly(arylene sulfide)s used herein and their method of preparation are well known in the art and are described for example, in U.S. Patent No. 3,354,129 to Edmonds, Jr. and Hill, Jr. issued on November 21, 1967; U.S. Patent Nos. 4,127,713 and 3,919,177 to Campbell; and U.S. Patent No. 4,645,826 to Iizuka et al., incorporated herein by reference. Depending upon the particular method of preparation, the PAS may exist as random or block homopolymers or copolymers. In general, such poly(arylene sulfide)s are prepared by the reaction of an alkali metal halide and a dihalo aromatic compound. When a branched polymer is desired, small amounts of an aromatic compound having three or more functionally reactive groups may also be present as a reactant, with trihalo aromatic compounds being representative of such compounds.

When it is desired to cross-link the poly(arylene sulfide) component, either during or subsequent to melt blending, it is generally recommended that this component have an initial weight average molecular weight of from about 10,000 to about 100,000 and an initial melt viscosity of from about 5 to about 400 Pa.S at 1,200 $sec^{-1}$ and 310°C, with initial weight average molecular weights of from about 20,000 to about 60,000 and melt viscosities of from about 5 to about 200 Pa.S at 1,200 $sec^{-1}$ and 310°C being of particular interest. As used herein the term "initial" as applied to the molecular weight or melt viscosity of the poly(arylene sulfide) means the molecular weight or melt viscosity of that component prior to its incorporation into the subject compositions. Cross-linking of the PAS will result in increases in both melt viscosity and molecular weight. In general, the extent to which the poly(arylene sulfide) is cross-linked will depend, in part, on its initial molecular weight and melt viscosity, the structural configuration of the polymer, and the rheological and physical properties required of the poly(arylene sulfide) in its end-use application.

While cross-linking may be utilized to increase polymer viscosity, excessive cross-linking, especially in the case of polymers having relatively high molecular weights, may result in the production of an intractable polymer having undesirable rheology and flow properties. Excessive cross-linking may also result in the formation of brittle materials having undesirable elongation or impact properties, particularly where the starting material is itself a branched polymer. In the case where crosslinking is achieved during or subsequent to the incorporation of the poly(arylene sulfide) component into the compositions of this invention, the degree of cross-linking is correlated to the viscosity of the resultant compositions. For purposes of this invention, the degree of cross-linking should not result in the production of compositions having viscosities which exceed 900 Pa.S at 400 $sec^{-1}$ and 316°. For numerous applications, it is particularly desirable that the melt viscosity of the subject composition range from about 150 to about 400 Pa.S at 400 $sec^{-1}$ and 316°.

Post polycondensation cross-linking of the poly(arylene sulfide) may be accomplished by a variety of techniques that are known in the art, for example by thermal curing, acid treatment, or the use of a chemical additive, i.e., a cross-linking agent,. Thermal curing is described, for example, in U.S. Patent No. 3,793,256 to Scoggins and U.S. Patent No. 4,839,411 to Hoover et al., incorporated herein by reference. Acid treatments are described, for example, in U.S. Patent No. 4,801,664 to Nesheiwat et al. and U.S. Patent No. 4,769,426 to Iwasaki et al., incorporated herein by reference. Exemplary of the use of chemical additives to cross-link poly(arylene sulfide)s is U.S. Patent No. 4,917,957 to Nitoh et al., incorporated herein by reference.

Thermal curing may be accomplished by subjecting a low viscosity poly(arylene sulfide) or a resin composition containing a low viscosity poly(arylene sulfide) to an oxidative atmosphere at an elevated temperature below the poly(arylene sulfide)'s melting point for a period of time sufficient to effect the desired viscosity increase. Acid treatments typically involve contacting a low viscosity poly(arylene sulfide), generally in the form of an aqueous slurry, with an aqueous acid solution, heating the resulting acid slurry at elevated temperatures to effect curing, and recovering the cured poly(arylene sulfide).

When chemical additives are utilized to effect post polycondensation cross-linking, cross-linking is typically

effected during melt compounding. For purposes of this invention, when a cross-linking agent is present during melt compounding, it is frequently desirable to utilize a poly(arylene component) that prior to cross-linking is linear in structure. Use of highly branched polymers in conjunction with a cross-linking agent may result in the production of a brittle, intractable polymer. In the practice of this invention, cross-linking agents are generally present in an amount up to about 5 percent by weight, preferably from about 0.5 to about 2 percent by weight, based on the weight of the PAS component. Use of less than about 0.1 percent by weight, based on the weight of the PAS may fail to achieve the desired increase in viscosity, whereas, the use of in excess of about 5 percent by weight of cross-linking agent may deleteriously impact flow and rheological characteristics.

Cross-linking agents may be incorporated into the subject compositions in a single compounding operation or in a separate compounding step. For reasons of convenience and efficiency it is recommended that the cross-linking agent be added with other composition components in a single compounding step. Single step addition of the cross-linking agent also minimizes the thermal history of the poly(arylene sulfide).

Cross-linking agents which may be employed in the practice of this invention include a variety of commercially available materials such as silanes, mercaptans, titanates, zirconates, aluminates, and the like. Silanes are of particular interest, and include, for example, aminosilanes, alkoxysilanes, mercaptosilanes, vinylsilanes, epoxysilanes, aminoalkoxysilanes, epoxyalkoxysilanes, mercaptoalkoxysilanes, vinylalkoxysilanes, and the like. Representative cross-linking agents and their use in the production of cross-linked poly(arylene sulfide)s are set forth in the patent to Nitoh et al. previously referenced. The cross-linking reaction being time and temperature dependant, the use of extrusion temperatures of from about 280°C to about 360°C and residence times of from about 0.5 to about 4 minutes are generally recommended, however, those skilled in the art will readily appreciate that modification of these parameters may be used to tailor the crosslinking reaction to their particular requirements.

As an alternative to cross-linking the poly(arylene sulfide) during or subsequent to melt compounding, at least a portion of the PAS may be cross-linked prior to incorporation into the compositions of this invention. The amount and degree of crosslinked PAS which is so incorporated is dependant upon the presence and relative amount of non-cross-linked PAS and the viscosity requirements of the melt blended composition. The relative amounts of cross-linked and non-cross-linked PAS should not, however, result in the production of compositions having a melt viscosity in excess of about 900 Pa.S at 400 $sec^{-1}$ and 316°C. When utilizing a highly cross-linked PAS, i.e., a PAS having a melt viscosity in excess of about 10,000 Pa.S at 2 $sec^{-1}$ and 310°C, it is generally recommended that the amount of such highly cross-linked PAS not exceed about 15 percent by weight of the total amount of PAS, and that the balance of the PAS component have a melt visosity of up to about 200 Pa.S at 1200 $sec^{-1}$ and 310°C. It will be apparent to those skilled in the art that it may be possible to utilize somewhat greater amounts of a PAS having a lesser degree of cross-linking. When a portion of the PAS component is cross-linked prior to incorporation into the subject compositions, it may not be desirable to either add a cross-linking agent or to subject the composition to a heat or other cross-linking treatment.

The amorphous silica used in the practice of this invention is silicon dioxide of an extremely small particle size, i.e., particles which provide a surface area of from about 50 to about 500 $m^2/g$ of material. Examples of the amorphous silicas which are suitable for use in the practice of this invention are precipitated silica and fumed silica. For purposes of this invention amorphous silica having a surface area of from about 80 to about 400 $m^2/g$, in particular, from about 80 to about 250 $m^2/g$, are preferred.

It has been observed that the presence of free hydroxyl groups (which is characteristic of untreated amorphous silica), frequently results in a hydrophilic, moisture sensitive particle which can result in the production of compositions of variable viscosity. When stable, reproducible viscosities are desired, it is preferred that the amorphous silica be hydrophobic in nature. The amorphous silica may be rendered hydrophobic by surface treatment with a sizing or surface modifying agent having the tendency to repel water, for example, hexamethyldisilazane, dimethyldichlorosilane, dimethyl silicon fluid, and the like. Alternatively, it may be possible to counteract the tendency of untreated amorphous silica to absorb water by introducing a hydrophobic agent directly into the subject compositions. Surface treatment of the silica is, however, the preferred means of producing hydrophobic particles.

Amorphous silica suitable for use in the practice of this invention is available from numerous suppliers including Cabot Company, Degussa AG, Wacker Chemie, and Tulco Inc. Of particular interest are several fumed silica products sold by Cabot Company under the trade name Cab-O-Sil, especially those hydrophobic products designated as grades TS-530, TS-610, and TS-720.

The amorphous silica is typically present in the compositions of this invention in an amount of at least about 1 percent by weight, preferably from about 1 to about 10 percent by weight, based on the weight of the poly(arylene sulfide). The use of lesser amounts of fumed silica will ordinarily fail to achieve reductions in flash, whereas, at levels exceeding about 10 percent by weight, additional benefits in flash reduction may not be realized. While the use of higher levels of this additive may be possible, from a cost perspective, it is generally

unwarranted. Additionally, an excess amount of this additive may result in a deterioration of physical and/or rheological properties of the PAS component. It has been found that the use of hydrophobic fumed silica in an amount of from about 1 to about 5 percent by weight, based on the weight of the poly(arylene sulfide), generally does not result in a significant increase in the melt viscosity of the resultant composition and, in some instances, may actually lower melt viscosity.

Reinforcing fillers, such as, for example, glass, mica, talc, mineral fillers, and the like, will typically account for up to about 60 percent of the total weight of the composition of this invention. The use of in excess of about 60 weight percent of reinforcing filler can result in lower mechanical properties and poor flow. For many electrical/electronic applications the use of glass fiber in an amount of from about 30 to about 50 percent by weight, based on the total composition weight is recommended. In the case of glass fibers, such fibers preferably have an average diameter of about 5 to about 15 microns, more preferably, from about 9 to about 14 microns.

Depending on the objects being formed and the processing techniques employed, the compositions of this invention may further comprise one or more optional additives such as, for example, antioxidants, heat stabilizers, ultraviolet stabilizers, mold release agents, lubricants, plasticizers, flame retardants, pigments and the like. The total amount of all such optional additives typically will not exceed about 5 percent by weight of the total weight of the composition and often will not exceed about 2 percent of the total weight of the composition.

In an embodiment of particular interest, this invention relates to a melt blend of a mixture consisting essentially of:

(a) from about 50 to about 70 percent by weight, based on the total weight of the mixture, of a linear poly(phenylene sulfide) having a melt viscosity of from about 5 to about 200 Pa.S at 1,200 $sec^{-1}$ and 310°C;
(b) from about 30 to about 50 percent by weight, based on the total weight of the mixture of glass fiber;
(c) from about 1 to about 5 percent by weight, based on the weight of the poly(phenylene sulfide), of a hydrophobic amorphous silica having a surface area of from about 80 to about 250 $m^2/g$; and
(d) a cross-linking agent present in an amount of up to about 5 percent by weight, based on the weight of the poly(phenylene sulfide),

wherein the melt blend has a melt viscosity of from about 150 to about 400 Pa.S at 400 $sec^{-1}$ and 316°C.

In another embodiment of interest, this invention is directed to a melt blend which consists essentially of:
(a) from about 50 to about 70 percent by weight, based on the total weight thereof, of poly(phenylene sulfide);
(b) from about 30 to about 50 percent by weight, based on the total weight thereof, of glass fiber;
(c) from about 1 to about 5 percent by weight, based on the weight of the poly(phenylene sulfide), of a hydrophobic amorphous silica having a surface area of from about 80 to about 250 $m^2/g$,

wherein the melt blend has a melt visosity of from about 150 to about 400 Pa.S at 400 $sec^{-1}$ and 316°C and wherein the poly(phenylene sulfide), prior to melt blending, consists essentially of a combination of from about 90 to about 97 percent by weight of a linear poly(phenylene sulfide) having a melt viscosity of from about 5 to about 200 poise at 1,200 $sec^{-1}$ and 310°C and from about 3 to about 10 percent by weight of a cross-linked poly(phenylene sulfide) having a melt viscosity of from about 80,000 to about 120,000 Pa.S at 2 $sec^{-1}$ and 310°C.

The compositions of this invention can be prepared by conventional melt blending techniques wherein the poly(arylene sulfide), fumed silica, reinforcing filler and any optional components are combined under conditions of elevated temperature and shear. The order in which the components are combined is not critical, thus, various components can be combined in a single or multiple step(s). Desirable melt blends are generally prepared by co-extrusion of the resin components at a temperature of up to about 360°C. For purposes of this invention, preferred melt temperatures are from about 280°C to about 340°C, with compositions containing higher viscosity poly(arylene sulfide) components being extruded at higher temperatures than compositions containing lower viscosity poly(arylene sulfide) components. Depending upon the particular components utilized and their relative amounts, melt compounding at temperatures in excess of 360°C can result in deterioration of the physical properties of the resulting compositions.

In use, the compositions of this invention can be fabricated into a variety of molded or extruded articles. Injection molded parts can be produced under conditions employing injection pressures of from about 20 to about 125 MPa, melt temperatures of from about 280 to about 360°C, and cycle times of from about 0.5 to about 2 minutes, although, it will be readily apparent to one skilled in the art that particular processing conditions will be widely variable depending upon factors which include mold size and configuration, choice of equipment, shear rate, screw design, and the like.

EXAMPLES

The following examples are presented to further illustrate this invention. The examples are not, however,

intended to limit the invention in any way. Unless otherwise indicated, all parts and percentages are by weight based on total composition weight.

Compositions as described in the tables which follow were compounded by mixing the specified components in the described proportions and melt blending the resulting mixtures on a 40 mm ZSK twin screw extruder to produce an extrudate which was cooled and pelletized. Extrusion conditions were as follows:

melt temperature: 310 to 340°C
die temperature: 300 to 320°C
screw speed: 200 rpm

Several of the components listed in the Tables are more specifically described as follows:

PPS A - A linear poly(phenylene sulfide) having a melt viscosity of 56 Pa.S at 1200 $sec^{-1}$ and 310°C and a weight average molecular weight of about 40,000.

PPS B - A linear poly(phenylene sulfide) having a melt viscosity of 24 Pa.S at 1200 $sec^{-1}$ and 310°C and a weight average molecular weight of about 30,000.

PPS C - A linear poly(phenylene sulfide) having a melt viscosity of 140 Pa.S at 1200 $sec^{-1}$ and 310°C and a weight average molecular weight of about 60,000.

PPS D - Cross-linked poly(phenylene sulfide) having a melt viscosity of about 100,000 poise at 2 $sec^{-1}$ and 310°C.

Cab-O-SIL TS-530 - Hydrophobic fumed silica from Cabot Company, having a surface area of 200 ± 40 $m^2/g$ and surface treated with hexamethyldisilazane.

CAB-O-SIL TS-610 - Hydrophobic fumed silica from Cabot Company, having a surface area of 120 ± 20 $m^2/g$ and surface treated with dimethyldichlorosilane.

CAB-O-SIL TS-720 - Hydrophobic fumed silica from Cabot Company, having a surface area of 100 ± 20 $m^2/g$ and surface treated with dimethyl silicon fluid.

CAB-O-SIL PTG - Fumed silica from Cabot Company, having a surface area of 200 ± 25 $m^2/g$ which is hydrophilic in nature.

Silane - A difunctional silane which functions as a cross-linking agent in the described compositions.

Flash data for the described compositions were obtained utilizing a 20,000 Kg press, 0.042 Kg barrel, Boy molding machine equipped with a single cavity, center sprue gated mold, configured in the shape of a disk 5.09 cm in diameter and 0.32 cm thick and having 2 sets of five tabs located around the disk's perimeter. The tabs in each set were 3.50 cm long, measured from the edge of the disk to the end of the tab, 0.61 cm wide, and had thicknesses of 10, 20, 30, 60 and 1000 microns, respectively. Tab sets in the mold were located opposite one another on the disk. Within a set, tabs were positioned 26° apart from one another. An illustration of this part design is provided by Figures 1 and 2. Figure 1 represents a frontal cross-sectional view of the molded part. Figure 2 represents a top view of the molded part.

Molding conditions used with the flash mold were as follows:

melt temperature - 310-320°C
mold temperature - 135°C
cycle time - 30 sec.

Prior to molding, resins were dried at 130°C for 4 hours to remove surface moisture. During molding, the injection pressure was increased by increments of 8.62 MPa until reaching a pressure at which the 1000 micron tabs were filled. At this pressure, the extent to which the thinner tabs were filled was dependant upon the flow characteristics of the molten resin. The length of the solidified material which collected in the tabs simulated flash as a function of mold clearance and injection pressure.

Reported flash values were obtained from optical projection measurements of solidified material which collected in the 60 micron tabs taken from a series of 10 molded disks. Two sets of measurements were taken from each tab; one being the distance from the tab base to the point of longest flow, the other being the distance from the tab base to the point of shortest flow. The 20 values in each set of measurements were averaged to provide a maximum flash length and a minimum flash length for the series of 10 disks. The maximum and minimum flash lengths were then averaged to provide the reported flash value.

## EXAMPLES $E_1$ THROUGH $E_5$ AND COMPARATIVE EXAMPLES $C_1$ THROUGH $C_4$

Compositions as described in Table 1 were compounded and molded as set forth above. Flash values and melt viscosities for these compositions are provided in Table 2. Melt viscosities were obtained using a Kayness capillary rheometer at a melt temperature of 316°C and a shear rate of 400 $sec^{-1}$. Examples $E_2$ and $E_3$ showed significantly reduced flash values compared to Comparative Example $C_2$ which lacked an amorphous silica component. Example $E_1$ which contained fumed silica having a hydrophilic surface was shown to have somewhat reduced flash as compared to Comparative Example $C_2$, however, the melt viscosity of the composition

was not consistently reproducible. Examples $E_4$ and $E_5$ were shown to have significantly reduced flash values compared to a control lacking a fumed silica additive, i.e., $C_4$. Examples $E_2$ through $E_5$ which contained hydrophilic fumed silica, were also found to exhibit viscosity values which were similar to the data obtained for their respective controls which contained no fumed silica.

**TABLE 1**

**COMPOSITION**

| **Component (Weight %)** | **$C_1$** | **$C_2$** | **$E_1$** | **$E_2$** | **$E_3$** | **$C_3$** | **$C_4$** | **$E_4$** | **$E_5$** |
|---|---|---|---|---|---|---|---|---|---|
| PPS A | 59.7 | 59.2 | 58.2 | 58.2 | 58.2 | -- | -- | -- | -- |
| PPS B | -- | -- | -- | -- | -- | 59.7 | 59.2 | 57.95 | 57.95 |
| Glass Fiber | 40.0 | 40.0 | 40.0 | 40.0 | 40.0 | 40.0 | 40.0 | 40.0 | 40.0 |
| CAB-O-SIL TS-530 | -- | -- | -- | -- | -- | -- | -- | 1.0 | -- |
| CAB-O-SIL TS-610 | -- | -- | -- | 1.0 | -- | -- | -- | -- | 1.0 |
| CAB-O-SIL TS-720 | -- | -- | -- | -- | 1.0 | -- | -- | -- | -- |
| CAB-O-SIL PTG | -- | -- | 1.0 | -- | -- | -- | -- | -- | -- |
| Silane | -- | 0.5 | 0.5 | 0.5 | 0.5 | -- | 0.5 | 0.75 | 0.75 |
| Lubricant | 0.3 | 0.3 | 0.3 | 0.3 | 0.3 | 0.3 | 0.3 | 0.3 | 0.3 |

**TABLE 2**

| | Injection Pressure (MPa) | Flash Length ($\mu$) | Viscosity (Pa.S) |
|---|---|---|---|
| **COMPOSITION** | | | |
| $C_1$ | 20.7 | 380 | 228 |
| $C_2$ | 27.6 | 150 | 390 |
| $E_1$ | 27.6 | 106 | 122-380 |
| $E_2$ | 27.6 | 80 | 342 |
| $E_3$ | 27.6 | 90 | 433 |
| $C_3$ | 20.7 | 380 | 185 |
| $C_4$ | 20.7 | 160-170 | 260-280 |
| $E_4$ | 20.7 | 60 | 238 |
| $E_5$ | 20.7 | 50 | 242 |

EXAMPLES $E_6$ THROUGH $E_{10}$ AND COMPARATIVE EXAMPLES $C_5$ AND $C_6$

Compositions as described in Table 3 were compounded and molded as set forth above. Flash values and melt viscosities for these compositions are provided in Table 4. Melt viscosities were obtained using a Kayeness capillary rheometer at a melt temperature of 316°C and a shear rate of 400 $sec^{-1}$. Compared to Comparative Example $C_5$ (which lacked a fumed silica additive), Examples $E_6$ and $E_7$ showed significant reductions in flash. Similarly, compared to Comparative Example $C_6$ (which lacked a fumed silica additive), Examples $E_8$ through $E_{10}$ showed significant reductions in flash. Example $E_7$ which contained hydrophobic fumed silica in an amount of 2 weight percent, based on the total weight of the composition, required the use of higher injection pressures to provide complete mold fill as compared to Example $E_6$ which contained this additive in an amount of 1 weight percent based on the total weight of the composition.

**TABLE 3**

**COMPOSITION**

| **COMPONENT** (Weight %) | $C_5$ | $E_6$ | $E_7$ | $C_6$ | $E_8$ | $E_9$ | $E_{10}$ |
|---|---|---|---|---|---|---|---|
| PPS C | 18.2 | 17.9 | 17.6 | 17.4 | 17.1 | 17.1 | 17.1 |
| PPS B | 36.5 | 35.8 | 35.1 | 34.8 | 34.1 | 34.1 | 34.1 |
| PPS D | 5.0 | 5.0 | 5.0 | 7.5 | 7.5 | 7.5 | 7.5 |
| Glass Fiber | 40 | 40 | 40 | 40 | 40 | 40 | 40 |
| CAB-O-SIL TS-530 | -- | -- | -- | -- | -- | 1.0 | -- |
| CAB-O-SIL TS-610 | -- | -- | -- | -- | -- | -- | 1.0 |
| CAB-O-SIL TS-720 | -- | 1.0 | 2.0 | -- | 1.0 | -- | -- |
| Lubricant | 0.3 | 0.3 | 0.3 | 0.3 | 0.3 | 0.3 | 0.3 |

**TABLE 4**

| **Composition** | Injection Pressure (MPa) | Flash Length (μ) | Viscosity (Pa.S) |
|---|---|---|---|
| $C_5$ | 20.7 | 150 | 241 |
| $E_6$ | 20.7 | 110 | 246 |
| $E_7$ | 27.6 | 90 | 295 |
| $C_6$ | 27.6 | 150 | 289 |
| $E_8$ | 27.6 | 70 | 340 |
| $E_9$ | 27.6 | 110 | 323 |
| $E_{10}$ | 27.6 | 90 | 342 |

EXAMPLES $E_{11}$ AND $E_{12}$ AND COMPARATIVE EXAMPLES $C_7$ THROUGH $C_9$

Compositions as described in Table 5 were compounded and molded as set forth above. Flash values and melt viscosities for these compositions are provided in Table 6. Melt viscosities were obtained using a Kayeness capillary rheometer at a melt temperature of 316°C and a shear rate of 400 $sec^{-1}$. Compared to Comparative Examples $C_7$ through $C_9$ (which lacked a fumed silica additive), Examples $E_{11}$ and $E_{12}$ showed significant reductions in flash.

| TABLE 5 | | | | | |
|---|---|---|---|---|---|
| COMPOSITION | | | | | |
| **COMPONENT** (Weight %) | $C_7$ | $C_8$ | $C_9$ | $E_{11}$ | $E_{12}$ |
| PPS A | 59.7 | --- | --- | --- | ---- |
| PPS B | --- | 59.7 | --- | 49.23 | 27.35 |
| PPS C | --- | --- | 59.7 | 5.47 | 27.35 |
| Glass Fiber | 40 | 40 | 40 | 40 | 40 |
| CAB-O-SIL TS-530 | --- | --- | -- | -- | 5 |
| CAB-O-SIL TS-610 | -- | -- | -- | 5 | -- |
| Lubricant | 0.3 | 0.3 | 0.3 | 0.3 | 0.3 |

| TABLE 6 | | | |
|---|---|---|---|
| **Composition** | Injection Pressure (MPa) | Flash Length (μ) | Viscosity (Pa.S) |
| $C_7$ | 20.7 | 380 | 228 |
| $C_8$ | 20.7 | 380 | 184 |
| $C_9$ | 27.6 | 280 | 433 |
| $E_{11}$ | 20.7 | 170 | 166 |
| $E_{12}$ | 27.6 | 170 | 298 |

## Claims

**1.** A molding composition which comprises a melt blend of:
(a) poly(arylene sulfide);
(b) reinforcing filler; and
(c) a flash reducing amount of an amorphous silica having a surface area of from about 50 to about 500 $m^2/g$,
wherein the composition has a melt viscosity of from about 150 to about 900 Pa.S at 400 $sec^{-1}$ and 316°C.

**2.** A composition as described in claim 1 wherein the poly(arylene sulfide) is a poly(phenylene sulfide) having a melt viscosity of from about 5 to about 400 Pa.S at 1,200 $sec^{-1}$ and 310°C prior to incorporation into the melt blend.

**3.** A composition as described in claim 1 wherein the composition has a melt viscosity of from about 150 to about 400 Pa.S at 400 $sec^{-1}$ and 316°C.

**4.** A composition as described in claim 3 wherein the amorphous silica is a hydrophobic amorphous silica.

**5.** A composition as described in claim 4 wherein the poly(arylene sulfide) is poly(phenylene sulfide).

**6.** A composition as described in claim 2 wherein the poly(arylene sulfide) is poly(phenylene sulfide), the reinforcing filler is glass fiber, and the amorphous silica is hydrophobic fumed silica having a surface area of from about 80 to about 400 $m^2/g$.

**7.** A composition as described in claim 6 wherein the hydrophobic fumed silica is present in an amount of from about 1 to about 10 percent by weight, based on the weight of the poly(phenylene sulfide).

8. A composition as described in claim 6 wherein the glass fiber has an average diameter of from about 5 to about 15 microns and is present in an amount of from about 30 to about 50 percent by weight based on the total weight of the composition.

9. A melt blend which comprises:
(a) a poly(arylene sulfide), at least a portion of which is cross-linked;
(b) up to about 60 percent by weight, based on the total weight of the composition of reinforcing filler;
(c) and from about 1 to about 10 percent by weight, based on the weight of the poly(arylene sulfide), of an amorphous silica having a surface area of from about 50 to about 500 $m^2/g$,
wherein the melt blend has a melt viscosity of from about 150 to about 900 Pa.S at 400 $sec^{-1}$ and 316°C.

10. A melt blend as described in claim 9 wherein the reinforcing filler is present in an amount of from about 30 to about 50 percent by weight, based on the total weight of the composition.

11. A melt blend as described in claim 9 wherein the poly(arylene sulfide) prior to incorporation into the melt blend has a weight average molecular weight of from about 10,000 to about 100,000 and a melt viscosity of from about 5 to about 400 Pa.S at 1,200 $sec^{-1}$ and 310°C.

12. A melt blend as described in claim 11 wherein the poly(arylene sulfide) is a poly(phenylene sulfide) having a weight average molecular weight of from about 20,000 to about 60,000 and a melt viscosity of from about 5 to about 200 Pa.S at 1,200 $sec^{-1}$ and 310°C.

13. A melt blend as described in claim 11 wherein at least a portion of the poly(arylene sulfide) is cross-linked.

14. A melt blend as described in claim 9 which further comprises at least one additional component selected from the group consisting of antioxidants, heat stabilizers, ultraviolet stabilizers, mold release agents, lubricants, plasticizers, flame retardants and pigments.

15. A melt blend of a mixture consisting essentially of:
(a) from about 50 to about 70 percent by weight, based on the total weight of the mixture, of a linear poly(phenylene sulfide) having a melt viscosity of from about 5 to about 200 Pa.S at 1,200 $sec^{-1}$ and 310°C;
(b) from about 30 to about 50 percent by weight, based on the total weight of the mixture of glass fiber;
(c) from about 1 to about 5 percent by weight, based on the weight of the poly(phenylene sulfide), of a hydrophobic amorphous silica having a surface area of from about 80 to about 250 $m^2/g$; and
(d) a cross-linking agent present in an amount of up to about 5 percent by weight, based on the weight of the poly(phenylene sulfide),
wherein the melt blend has a melt viscosity of from about 150 to about 400 Pa.S at 400 $sec^{-1}$ and 316°C.

16. A melt blend as described in claim 15 wherein the amorphous silica is hydrophobic fumed silica having a surface area of from about 80 to about 250 $m^2/g$.

17. A melt blend as described in claim 15 wherein the crosslinking agent is a silane.

18. A melt blend which consists essentially of:
(a) from about 50 to about 70 percent by weight, based on the total weight thereof, of poly(phenylene sulfide);
(b) from about 30 to about 50 percent by weight, based on the total weight thereof, of glass fiber;
(c) from about 1 to about 5 percent by weight, based on the weight of the poly(phenylene sulfide), of a hydrophobic amorphous silica having a surface area of from about 80 to about 250 $m^2/g$,
wherein the melt blend has a melt visosity of from about 150 to about 400 Pa.S at 400 $sec^{-1}$ and 316°C and wherein the poly(phenylene sulfide), prior to melt blending, consists essentially of a combination of from about 90 to about 97 percent by weight of a linear poly(phenylene sulfide) having a melt viscosity of from about 5 to about 200 Pa.S at 1,200 $sec^{-1}$ and 310°C and from about 3 to about 10 percent by weight of a cross-linked poly(phenylene sulfide) having a melt viscosity of from about 80,000 to about 120,000 Pa.S at 2 $sec^{-1}$ and 310°C.

19. A process for reducing the flash of poly(arylene sulfide) compositions which comprises the steps of:
(A) combining:

(a) a poly(arylene sulfide);

(b) up to about 60 percent by weight, based on the total weight of the composition, of reinforcing filler; and

(c) from about 1 to about 10 percent by weight, based on the weight of the poly(arylene sulfide), of an amorphous silica having a surface area of from about 50 to about 500 $m^2/g$,

to form a raw material charge, and

(B) extruding the resulting raw material charge to produce a poly(arylene sulfide) composition which is a melt blend having a melt viscosity of from about 150 to 900 Pa.S at 400 $sec^{-1}$ and 316°C,

wherein the poly(arylene sulfide) is cross-linked by means selected from the group consisting of:

(1) incorporation into the raw material charge of up to about 5 percent by weight, based on the weight of the poly(arylene sulfide), of a cross-linking agent, with the proviso that when a cross-linking agent is incorporated into the raw material charge, the poly(arylene sulfide) prior to cross-linking is a linear material having a melt viscosity of from about 5 to about 400 Pa.S at 1200 $sec^{-1}$ and 310°C,

(2) curing the poly(arylene sulfide) prior to incorporation into the raw material charge, and

(3) curing the poly(arylene sulfide) subsequent to extrusion.

FIG. 1

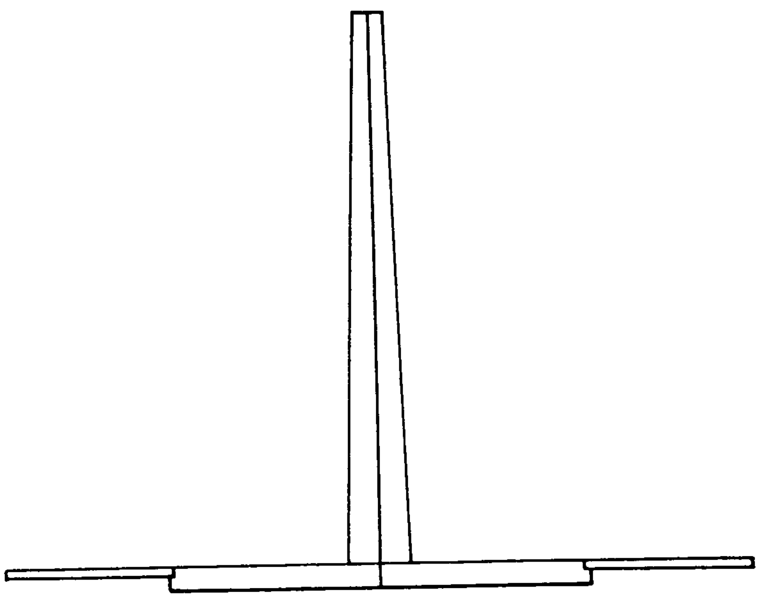

FIG.2

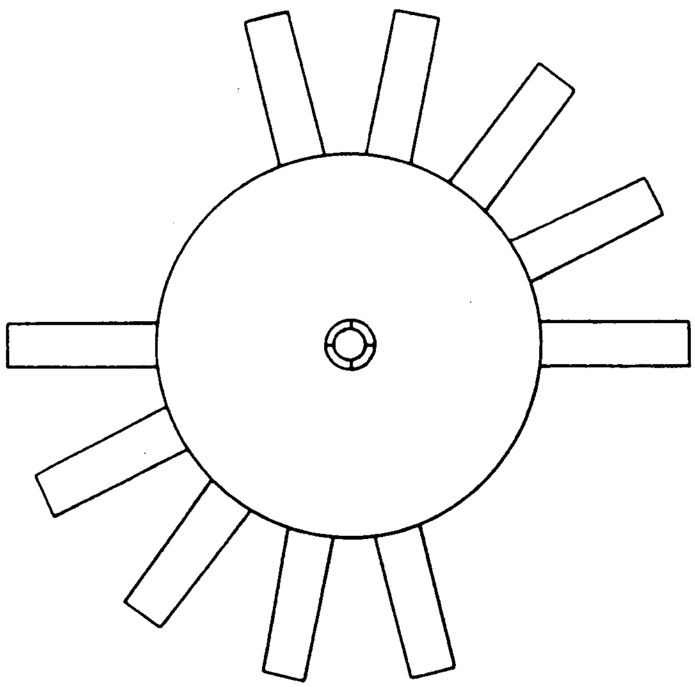

European Patent Office

# EUROPEAN SEARCH REPORT

Application Number
EP 93 30 7220

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| P,X | US-A-5 183 844 (V.C. VIVES)<br>* column 2, line 33 - line 44 *<br>* column 2, line 53 - line 57 *<br>* column 4, line 15 - line 40 *<br>* examples *<br>* claims 1-9 *<br>--- | 1-3,5 | C08K3/36<br>C08K7/14<br>C08L81/02 |
| A | EP-A-0 353 717 (IDEMITSU)<br>* page 8, line 25 - line 45 *<br>* page 10, line 19 - line 25 *<br>* claims 1,8-10 *<br>----- | 1,6,8 | |
| | | | **TECHNICAL FIELDS SEARCHED (Int.Cl.5)** |
| | | | C08K |

The present search report has been drawn up for all claims

| Place of search | Date of completion of the search | Examiner |
|---|---|---|
| THE HAGUE | 27 December 1993 | Engel, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)